# EUROPÄISCHE PATENTSCHRIFT

(11) **EP 3 586 071 B1**
(45) Veröffentlichungstag und Bekanntmachung des Hinweises auf die Patenterteilung: **21.04.2021**
(21) Anmeldenummer: 18707348.1
(22) Anmeldetag: 23.02.2018
(51) Int. Cl.: F24S 80/20, G02B 5/02, G02B 5/28, H01L 31/048, H01L 31/0216, H01L 31/0236

(54) **VERGLASUNGSEINHEIT, VERFAHREN ZU DEREN HERSTELLUNG UND DEREN VERWENDUNG**
GLAZING UNIT, METHOD FOR THE PRODUCTION THEREOF AND USE THEREOF
UNITÉ DE VITRAGE, PROCÉDÉ DE FABRICATION DE CELLE-CI ET UTILISATION DE CELLE-CI

(30) Priorität: 27.02.2017 DE 102017203105
(43) Veröffentlichungstag der Anmeldung: 01.01.2020
(60) Teilanmeldung: 20191257.3
(73) Patentinhaber: Fraunhofer-Gesellschaft zur Förderung der angewandten Forschung e.V., 80686 München (DE)
(72) Erfinder: HÖHN, Oliver, 79336 Herbolzheim (DE); KROYER, Thomas, 79100 Freiburg (DE); BLÄSI, Benedikt, 79102 Freiburg (DE); KUHN, Tilmann, 79856 Hinterzarten (DE); HINSCH, Andreas, 79254 Oberried (DE)
(74) Vertreter: Friese Goeden Patentanwälte PartGmbB
(86) Internationale Anmeldenummer: PCT/EP2018/054492
(87) Internationale Veröffentlichungsnummer: WO 2018/154045

(56) Entgegenhaltungen:
- WO-A1-2004/079278
- WO-A1-2014/045144
- WO-A1-2015/155357
- DE-A1-102013 205 671
- US-A1- 2005 150 864
- US-A1- 2008 316 594
- US-A1- 2009 153 953
- US-A1- 2010 208 338
- US-A1- 2011 134 515
- WEI ZHANG ET AL: "Highly Efficient Perovskite Solar Cells with Tunable Structural Color", NANO LETTERS, Bd. 15, Nr. 3, 11. März 2015 (2015-03-11), Seiten 1698-1702, XP055201121, ISSN: 1530-6984, DOI: 10.1021/nl504349z
- VON FREYMANN G ET AL: "Three-Dimensional Nanostructures for Photonics", ADVANCED FUNCTIONAL MATERIALS, WILEY - V C H VERLAG GMBH & CO. KGAA, DE, Bd. 20, Nr. 7, 9. April 2010 (2010-04-09), Seiten 1038-1052, XP001554262, ISSN: 1616-301X, DOI: 10.1002/ADFM.200901838 [gefunden am 2010-03-18]

## Beschreibung

Die Erfindung betrifft eine Verglasungseinheit, die mindestens ein Glas aufweist, sowie ein Verfahren zu deren Herstellung und deren Verwendung. Verglasungseinheiten der eingangs genannten Art können beispielsweise als Fassadenelement verwendet werden.

Der Markt für bauwerkintegrierte Photovoltaik (BIPV) und die gebäudeintegrierte Solarthermie weist national und weltweit sehr große Potentiale auf. Die bisher nur sehr eingeschränkten Gestaltungsmöglichkeiten sind ein Hindernisgrund für die breite Akzeptanz und Anwendung von solchen Technologien an Bauwerken. Um die Akzeptanz und Attraktivität zu erhöhen, werden zunehmend Solarmodule mit photovoltaischen Zellen und thermische Solarkollektoren angefragt, bei denen deren Funktion mit Hilfe von Farbeffekten maskiert werden können und welche somit nicht mehr wahrnehmbar sind. Besonders gewünscht ist die Möglichkeit, die Farbe gezielt und individuell (z.B. Strukturierung mit dem eigenen Firmenlogo) beeinflussen zu können und gleichzeitig einen möglichst hohen Wirkungsgrad zu erhalten. Dabei soll der Farbeindruck der Module vom Betrachtungswinkel möglichst unabhängig sein und Blendeffekte sollen je nach Einsatzort vermieden werden. Bisherige Konzepte weisen entweder einen nicht tolerierbaren Effizienzverlust auf, sind in der Farbwahl eingeschränkt oder industriell nicht umsetzbar.

Wenn man beispielsweise BIPV-Module optisch ansprechender gestalten will, dann gibt es grundsätzlich zwei unterschiedliche Optionen. Man kann versuchen, das Modul so zu gestalten, dass die Zellen nicht wahrnehmbar sind, indem vor die Zellen eine zum Beispiel farbige oder streuende Glasscheibe eingesetzt wird. Bei dieser Option sind die Solarmodule nicht mehr sichtbar. Dabei ist es wichtig, die durch die Glasscheibe bislang unvermeidliche Effizienzminderung zu minimieren, damit ein hinreichender Effekt auf die Energiebilanz des Gebäudes realisiert werden kann.

Alternativ dazu kann versucht werden, die Zellen sichtbar zu lassen und bewusst als Gestaltungselement einzusetzen, indem eine spezielle Form, Größe oder Position der Solarzellen gewählt wird.

Im Falle der ersten Option kann als farbige Glasscheibe das eingefärbte Moduldeckglas verwendet werden. Eine Möglichkeit ist die Einfärbung bzw. das Bedrucken des Glases mit absorbierenden Farbpigmenten. Dadurch ist zwar eine relativ freie und einfache Farbwahl möglich, aber aufgrund der Absorption eines Teilbereiches des elektromagnetischen Spektrums durch die Farbpigmente entstehen hohe Verluste, wenn eine echte unsichtbare Photovoltaik erreicht werden soll. Dadurch ist eine weite Akzeptanz praktisch ausgeschlossen. Auch lumineszente Materialien können eingesetzt werden, wobei hier der Gesamtwirkungsgrad gut bleibt. Allerdings ist auch bei der Verwendung lumineszenter Materialien eine industrielle Umsetzung noch weit entfernt und die Farbwahl hängt von der Farbe der verfügbaren lumineszenten Materialien ab und ist daher eingeschränkt.

Durch den Einsatz einer selektiv reflektierenden Deckschicht wird der Gesamtwirkungsgrad nur minimal beeinflusst und es erschließen sich weitere Gestaltungsspielräume. Nachteilig ist die Winkelabhängigkeit des Farbeindruckes, was bei Gebäuden in der Regel unerwünscht ist.

Eine Verglasungseinheit mit einer Beschichtung, welche das Problem der Winkelabhängigkeit mindert, ist aus der US 2015/0249424 A1 bekannt. Diese Beschichtung besteht aus einem komplexen Schichtaufbau und führt zu einem Reflexionsverlust von 8 % - 12 %. Ein entsprechendes Produkt (Kromatix™) ist in sechs verschiedenen Farben erhältlich. Allerdings weist diese Technologie erhebliche Nachteile auf. Der winkelunabhängige Farbeindruck beruht auf einem sehr speziellen, komplexen Dünnschichtfilter, was die Zahl der möglichen Farben und Freiheitsgrade sowie die erreichbare Farbsättigung einschränkt.

Eine Verglasungseinheit nach dem Oberbegriff des Anspruchs 1 ist aus der WO2015155357 bekannt.

Ausgehend von diesem Stand der Technik liegt der Erfindung somit die Aufgabe zugrunde, eine Verglasungseinheit mit verbesserten Eigenschaften bereitzustellen.

Die Aufgabe wird erfindungsgemäß durch eine Verglasungseinheit gemäß Anspruch 1, ein Verfahren zur Herstellung dieser Verglasungseinheit nach Anspruch 9, ein Solarmodul, das die Verglasungseinheit aufweist nach Anspruch 14 und einen thermischen Solarkollektor nach Anspruch 15 gelöst.

Vorteilhafte Weiterbildungen der Erfindung finden sich in den Unteransprüchen.

Erfindungsgemäß wird eine Verglasungseinheit zur ästhetischen Gestaltung beispielsweise von Fassadenflächen und Dachflächen vorgeschlagen, die mindestens eine photonische Struktur und ein Glas umfasst oder daraus besteht, wobei das Glas eine erste strukturierte Oberfläche aufweist, auf die die photonische Struktur aufgebracht ist.

Die erfindungsgemäße Verglasungseinheit enthält zumindest ein transparentes oder transluzentes Material als Substrat, welches nachfolgend als Glas bezeichnet wird. Das Substrat im Sinne der vorliegenden Erfindung kann auch einen mehrschichtigen Aufbau aufweisen, beispielsweise als Verbundsicherheitsglas, und daher auch Polymerfolien oder -schichten enthalten.

Photonische Strukturen im Sinne der vorliegenden Beschreibung sind in transparenten oder transluzenten Festkörpern vorkommende oder geschaffene Modulationen des Brechungsindex. Die photonische Struktur enthält somit zumindest erste Raumbereiche mit einem ersten Brechungsindex und zweite Raumbereiche mit einem zweiten Brechungsindex, so dass durch Beugung, Reflexion an Grenzflächen und/oder Interferenz die Propagation von Licht beeinflusst wird. Hierzu wird der Brechungsindex in mindestens einer Raumrichtung in Dimensionen moduliert, welche in der gleichen Größenordnung wie die Wellenlänge des relevanten Lichts liegen.

Die ersten und zweiten Raumbereiche können in einigen Ausführungsformen der Erfindung in Form einer Mehrzahl von Dünnschichten unterschiedlicher Zusammensetzung oder zwei verschiedener Zusammensetzungen und optional unterschiedlicher Dicke ausgeführt sein. In einigen Ausführungsformen kann die optische Schichtdicke der einzelnen Schichten etwa einem Viertel der Designwellenlänge entsprechen, bei welcher das Haupt-Reflexionsmaximum (0. Harmonische) erscheint.

Die erfindungsgemäß verwendeten photonische Strukturen sind dazu eingerichtet, ein erstes Teilspektrum eintreffender elektromagnetischer Strahlung zu reflektieren und ein zweites Teilspektrum eintreffender elektromagnetischer Strahlung zu transmittieren, wobei der reflektierte Anteil einer höheren Harmonischen entspricht und im sichtbaren Spektralbereich liegt. Eine höhere Harmonische weist dabei eine geringere Wellenlänge bzw. eine geringere mittlere Wellenlänge einer Wellenlängenverteilung auf als das Haupt-Reflexionsmaximum (0. Harmonische). In einigen Ausführungsformen der Erfindung kann die 2. oder 3. Harmonische verwendet werden. In dispersionsfreien Medien treten die höheren Harmonischen bei ganzzahligen Vielfachen der Frequenz des Haupt-Reflexionsmaximums (0. Harmonische) auf.

Erfindungsgemäß wurde erkannt, dass die Verwendung einer höheren Harmonischen eines Dünnschichtfilters im sichtbaren Spektralbereich eine höhere Farbsättigung und eine Vielzahl von möglichen Farben und Gestaltungsmöglichkeiten bietet. Durch die erfindungsgemäße Kombination der photonischen Struktur mit der strukturierten Oberfläche kann die Winkelabhängigkeit des Farbeindruckes reduziert oder aufgehoben werden. Ein mit der erfindungsgemäßen Verglasungseinheit versehenes Gebäude weist aus vielen oder allen Betrachtungswinkeln den identischen Farbeindruck auf.

Die ersten und zweiten Raumbereiche der photonischen Struktur können nicht-periodisch angeordnet sein.

Die ersten und zweiten Raumbereiche können periodisch angeordnet sein. Hierzu können Schichten gleicher Dicke und Zusammensetzung Verwendung finden. Die photonische Struktur kann beispielsweise durch Interferrenzeffekte Licht einer vorgebbaren Wellenlänge oder eines Wellenlängenbereiches reflektieren und andere Wellenlängen transmittieren. Die Reflektionswellenlänge oder der Maximalwert des Wellenlängenbereiches wird nachfolgend auch als Bragg-Wellenlänge bezeichnet. Die Breite des reflektierten Wellenlängenbereiches unter senkrechtem Einfall kann weniger als 75nm, weniger als 65nm oder weniger als 60nm betragen.

Erfindungsgemäß befindet sich eine solche photonische Struktur auf einer strukturierten Oberfläche des Glases. Das Glas weist dazu zumindest eine erste strukturierte Oberfläche auf, auf welche die photonische Struktur aufgebracht ist. Diese wird daher nachfolgend auch als dreidimensionale photonische Struktur bezeichnet. Die erste strukturierte Oberfläche kann eine Teilfläche einer Seite des Glases umfassen oder eine vollständige Seite des Glases kann mit der strukturierten Oberfläche versehen sein. Eine strukturierte Oberfläche im Sinne der vorliegenden Erfindung bezeichnet eine Struktur, welche Erhebungen und Vertiefungen aufweist. In einigen Ausführungsformen der Erfindung kann RMS-Rauheit zwischen etwa 30 nm und etwa 100 µm oder zwischen etwa 80 nm und etwa 10 µm liegen. Die strukturierte Oberfläche kann periodisch oder aperiodisch strukturiert sein.

Erfindungsgemäß wird in einigen Ausführungsformen ein Dünnschichtfilter als photonische Struktur auf eine strukturierte Oberfläche aufgebracht. Dieser Dünnschichtfilter ist damit ebenfalls strukturiert, sodass dieser nicht wie sonst üblich als planer Dünnschichtfilter betrachtet werden kann. Der Dünnschichtfilter kann dennoch als Bragg-Filter oder als ähnlicher Filter designt werden. Erfindungsgemäß wurde jedoch erkannt, dass sich einige Eigenschaften der als Dünnschichtfilter designten Struktur durch das Aufbringen auf ein strukturiertes Glas wesentlich ändern, sodass nicht mehr von einem eindimensionalen Dünnschichtfilter gesprochen werden kann. Erhalten bleiben bei dieser Realisierungsform die Hauptreflexionsmaxima, aber auch höhere Harmonische der Dünnschichtstruktur, wobei deren genaue Lage durch die durch die Schichtfolge der Einzelschichten des Dünnschichtfilters beeinflusst werden kann. Einer der wesentlichen Einflüsse der strukturierten Oberfläche ist der Einfluss auf die Winkelabhängigkeit der Reflexionspeaks. Ein planes Dünnschichtfilter auf einer strukturierten Oberfläche wird daher im Sinne der vorliegenden Beschreibung auch als dreidimensionale photonische Struktur bezeichnet.

In einigen Ausführungsformen kann der mittlere Brechungsindex der Verglasungseinheit größer als etwa 1,6 oder größer als etwa 1,8 oder größer als etwa 1,95 sein, jeweils bestimmt bei einer Wellenlänge von 550 nm. Der mittlere Brechungsindex ist definiert als mit der mit den Volumenanteilen des jeweiligen Materials gewichteten Mittelung des Brechungsindex. Dieser kann durch folgende Verfahrensschritte bestimmt werden:
Bestimmung der Gesamtdicke aller Schichten D_{ges} des Dünnschichtfilters der photonischen Struktur, beispielsweise durch Lichtmikroskopie oder Rasterelektronenmikroskopie,
Bestimmung der Anzahl unterschiedlicher Schichten des Dünnschichtfilters, beispielsweise mit EDX,
damit Bestimmung der Anzahl der Symmetrielemente N_{sym} des Dünnschichtfilters,
Bestimmung der Wellenlänge des Hauptpeaks LD_{HP},
Bestimmung der Wellenlänge der m. Harmonischen LDₘ,
Bestimmung von m über Division der Peakwellenlängen:
   m = LD_{HP}/LDₘ-1 und Runden auf eine ganze Zahl,
Berechnen des mittleren Brechungsindex n nach folgender Formel: n = N_{sym}/D_{ges} x 0.5 x LDₘ x (m+1)

Erfindungsgemäß wird zumindest eine erste Seite des Glases mit der erfindungsgemäßen photonischen Struktur versehen, welche auf einer strukturierten Oberfläche angeordnet ist. Diese erste Seite kann in einigen Ausführungsformen die von der Witterung abgewandte Innenseite sein, so dass die photonischen Struktur vor Bewitterung und Verschmutzung geschützt ist. In anderen Ausführungsformen der Erfindung kann die erste Seite des Glases mit der erfindungsgemäßen photonischen Struktur die bei Betrieb bzw. nach Endmontage außenliegende Oberfläche sein. Hierdurch kann die Farbsättigung erhöht sein.

Die photonische Struktur weist eine höhere Harmonische im sichtbaren Spektralbereich auf. Dies kann dadurch erfolgen, dass die Schichtdicken der photonische Struktur vergrößert werden. Dieses Merkmal hat die Wirkung, dass die spektrale Breite des reflektierten Wellenlängenbereiches kleiner wird. Eine höhere Harmonische zeichnet sich dadurch aus, dass die reflektierte Wellenlänge bzw. der Mittelwert eines Wellenlängenbereichs geringer ist als die reflektierte Wellenlänge bzw. der Mittelwert eines Wellenlängenbereichs der 0. Harmonischen bzw. der Hauptwellenlänge. In einigen Ausführungsformen der Erfindung handelt es sich bei der höhere Harmonischen um die 2. oder 3. Harmonische. Hierdurch kann die Farbsättigung in Reflektion und die Transmission erhöht sein. Somit steht ein größerer Anteil des Lichtspektrums zur Nutzung durch Photovoltaik oder thermische Kollektoren zur Verfügung und gleichzeitig nimmt ein Betrachter statt einzelner Zellen eine homogen gefärbte Fläche war.

In einigen Ausführungsformen der Erfindung können die Reflexionsverluste der Verglasungseinheit weniger als 12 % oder weniger als 9 % betragen.

Durch das Aufbringen der erfindungsgemäßen dreidimensionalen photonischen Struktur auf ein Modulglas eines Photovoltaikmoduls kann die erfindungsgemäße Verglasungseinheit als Teil eines Photovoltaikmoduls eingesetzt werden. Der Herstellungsprozess des Photovoltaikmoduls kann dabei nahezu unverändert bleiben. Gleichwohl ist die Farbgestaltung frei wählbar, so dass die erfindungsgemäßen Photovoltaikmodule einen breiteren Einsatzbereich aufweisen können. Die Photovoltaikmodule können an Flächen eingesetzt werden, an welchen sich der Einsatz konventioneller Photovoltaikmodule bislang aus gestalterischen Gründen verboten hat. In gleicher Weise können auch thermische Solarkollektoren mit der erfindungsgemäßen Verglasungseinheit ausgestattet werden. Weiterhin können Verglasungseinheiten mit der selektiven Schicht direkt ohne Lamination z.B. in nichtlaminierten Photovoltaikmodulen verwendet werden.

In einigen Ausführungsformen der Erfindung kann die photonische Struktur erste Schichten aufweisen, welche ein erstes Material enthalten, welches einen ersten Brechungsindex aufweist und die photonische Struktur kann zweite Schichten aufweist, welche ein zweites Material enthalten, welches einen zweiten Brechungsindex aufweist, wobei der erste Brechungsindex zwischen etwa 1,5 und etwa 2,2 beträgt und der zweite Brechungsindex zwischen etwa 1,8 und etwa 2,5 beträgt. Der Brechungsindexkontrast kann in einigen Ausführungsformen der Erfindung zwischen etwa 0,2 und etwa 0,9 betragen. Hierdurch wird die Farbsättigung erhöht und die Reflexionsverluste können weiter reduziert sein.

In einigen Ausführungsformen der Erfindung weist die dreidimensionale photonische Struktur einen Dünnschichtfilter auf oder besteht daraus, wobei der Dünnschichtfilter ein periodischer Dünnschichtfilter, insbesondere ein Bragg-Filter sein kann. Dabei kann der Bragg-Filter abwechselnd Schichten aus einem ersten Material und einem zweiten Material aufweisen oder daraus bestehen. Das erste und/oder das zweite Material kann ZrO₂ und/oder Nb₂O₅ und/oder TiO₂ und/oder Si₃N₄ und/oder SiO₂ und/oder AlN, SnO₂ und/oder Al₂O₃ und/oder HfO₂ und/oder Ta₂O₅ und/oder SiOₓN_{y} und/oder AlOₓN_{y} und/oder ZnO und/oder Bi₂O₃ und/oder In₂O₃ und/oder WO₃ und/oder MoO₃ enthalten oder daraus bestehen. In einigen Ausführungsformen der Erfindung kann das erste und/oder das zweite Material zusätzlich einen Dotierstoff enthalten.

Ausführungsbeispiele für Bragg-Filter sind die folgenden Schichtaufbauten a) bis c):
a) Si₃N₄ insbesondere in einer Dicke von 140 nm, TiO₂ insbesondere in einer Dicke von 170 nm, Si₃N₄ insbesondere in einer Dicke von 200 nm, TiO₂ insbesondere in einer Dicke von 170 nm und Si₃N₄ insbesondere in einer Dicke von 140 nm, oder
b) Si₃N₄ insbesondere in einer Dicke von 165 nm, TiO₂ insbesondere in einer Dicke von 190 nm, Si₃N₄ insbesondere in einer Dicke von 240 nm, TiO₂ insbesondere in einer Dicke von 190 nm und Si₃N₄ insbesondere in einer Dicke von 165 nm, oder
c) Si₃N₄ insbesondere in einer Dicke von 120 nm, TiO₂ insbesondere in einer Dicke von 140 nm, Si₃N₄ insbesondere in einer Dicke von 170 nm, TiO₂ insbesondere in einer Dicke von 140 nm und Si₃N₄ insbesondere in einer Dicke von 120 nm.

Um einen Oxidation der Si₃N₄-Schichten zu vermeiden, wenn diese eine äußere Schicht der photonischen Struktur bildet, kann darauf eine Passivierungsschicht angeordnet werden. Die Passivierungsschicht kann SiO₂ enthalten oder daraus bestehen und beispielsweise eine Dicke von etwa 120 nm bis etwa 210 nm aufweisen.

Beispiele von photonischen Strukturen und dem sich ergebenden Farbeindruck der Verglasungseinheiten sind in der folgenden Tabelle angegeben:

| | |
|---|---|
| grün | Strukturiertes Glas/Si₃N₄ 140 nm/TiO₂ 170 nm/Si₃N₄ 200 nm/TiO₂ 170 nm/Si₃N₄ 140 nm/SiO₂ 140 nm |
| rot | Strukturiertes Glas/Si₃N₄ 165 nm/TiO₂ 190 nm/Si₃N₄ 240 nm/TiO₂ 190 nm/Si₃N₄ 165 nm/SiO₂ 210 nm |
| blau | Strukturiertes Glas/Si₃N₄ 120 nm/TiO₂ 140 nm/Si₃N₄ 170 nm/TiO₂ 140 nm/Si₃N₄ 120 nm/SiO₂ 120 nm |
| grün alternativ | Strukturiertes Glas/Si₃N₄ 140 nm/TiO₂ 170 nm/Si₃N₄ 140 nm/SiO₂ 140 nm |
| rot alternativ | Strukturiertes Glas/Si₃N₄ 165 nm/TiO₂ 190 nm/Si₃N₄ 165 nm/SiO₂ 210 nm |
| blau alternativ | Strukturiertes Glas/Si₃N₄ 120 nm/TiO₂ 140 nm/Si₃N₄ 120 nm/SiO₂ 120 nm |

In einigen Ausführungsformen kann die optionale Deckschicht, welche SiO₂ enthält oder daraus besteht, auch entfallen. Zum Schutz vor Umwelteinflüssen können solche Verglasungseinheiten ohne abschließende SiO₂-Schicht in zumindest einer Polymerfolie laminiert werden. Sofern eine solche Lamination entfällt, kann die abschließende SiO₂-Schicht mit einer Dicke zwischen etwa 100 nm und etwa 230 nm die Gesamtreflexion vermindern und/oder die Degeneration durch Umwelteinflüsse reduzieren. Sofern vorgesehen ist, die Verglasungseinheit zu laminieren, kann eine abschließende SiO₂-Schicht die Verbindung zur Laminierfolie verbessern. Hierzu kann die abschließende SiO₂-Schicht auch dünner gewählt sein und beispielsweise eine Dicke zwischen etwa 5 nm und etwa 50 nm oder zwischen etwa 3 nm und etwa 100 nm aufweisen.

Dabei bedeutet der Ausdruck "strukturiertes Glas" ein Glas, das eine erste strukturierte Oberfläche aufweist, auf das Dünnschichtfilter als dreidimensionale photonische Struktur aufgebracht ist.

In einigen Ausführungsformen weist die Verglasungseinheit mehrere dreidimensionale photonische Strukturen auf, welche jeweils unterschiedliche Wellenlängenbereiche reflektieren. In einigen Ausführungsformen der Erfindung können 2 oder 3 dreidimensionale Strukturen verwendet werden, welche unterschiedliche Farben ergeben, z.B. rot, grün und blau. Dadurch ist es möglich, durch additive Farbmischung einen breiten Farbraum aufzuspannen.

Ein solcher breiter Farbraum kann auch erreicht werden, indem eine einzige dreidimensionale photonische Struktur mit mehreren Reflexionspeaks mit voneinander verschiedenen Wellenlängen bzw. Wellenlängenbereichen verwendet wird. Dies kann in einigen Ausführungsformen der Erfindung durch nichtperiodische Strukturen oder durch periodische Strukturen mit mehreren verschiedenen Schichtdicken erreicht werden.

In einigen Ausführungsformen kann das in der Verglasungseinheit vorliegende Glas eine zweite strukturierte Oberfläche aufweisen, die sich gegenüber der ersten strukturierten Oberfläche befindet. Die zweite strukturierte Oberfläche kann beispielsweise als Entspiegelungsschicht dienen. In dieser Ausführung ist durch die entfallende Reflexion der Vorderseite eine noch höhere Farbsättigung erreichbar.

In einigen Ausführungsformen kann die Verglasungseinheit erste Teilflächen aufweisen, welche eine erste photonische Struktur aufweisen und zweite Teilflächen aufweisen, welche eine zweite photonische Struktur oder keine photonische Struktur aufweisen. Wenn Teilflächen der Verglasungseinheit keine photonische Struktur aufweisen, erscheinen diese schwarz. Wenn Teilflächen der Verglasungseinheit eine andere photonische Struktur aufweisen als andere Teilflächen, so können diese in einer anderen Farbe erscheinen, wenn sich die Schichtdicken oder das Material der Einzelschichten unterscheiden. In anderen Ausführungsformen der Erfindung können Teilflächen mit dem identischen Bragg-Filter versehen sein, aber eine geringere Rauheit bzw. eine andere Oberflächenstrukturierung aufweisen. Hierdurch kann sich eine Winkelabhängigkeit des Farbeindruckes einstellen. Durch die Aufteilung in erste und zweite Teilflächen können Muster, Logos oder andere gestalterische Elemente auf der Verglasungseinheit ausgeführt werden.

Erfindungsgemäß wird weiter ein Verfahren zur Herstellung einer erfindungsgemäßen Verglasungseinheit bereitgestellt. Dabei wird zuerst die erste strukturierte Oberfläche auf dem Glas hergestellt und dann auf diese erste strukturierte Oberfläche die dreidimensionale photonische Struktur aufgebracht.

In einigen Ausführungsformen kann das Aufbringen der dreidimensionalen photonischen Struktur auf der ersten strukturierten Oberfläche des Glases durch Sputtern erfolgen. Dabei handelt es sich um einen weit verbreiteten Prozess zur Beschichtung von Architekturglas, so dass die erfindungsgemäße Verglasungseinheit einfach mit bestehenden Anlagen hergestellt werden kann. Bei diesem Verfahren können somit übliche Abdeckgläser für Solarmodule und thermische Solarkollektoren verwendet werden, die dann in üblicher Weise zur weiteren Herstellung der Solarmodule bzw. thermischen Solarkollektoren verwendet werden können.

In einigen Ausführungsformen kann die Herstellung der ersten strukturierten Oberfläche des Glases durch Sandstrahlen, Prägen, Ätzen, Gießen oder Walzen erfolgen. Wie bereits vorstehend ausgeführt wurde, kann in einigen Ausführungsformen die Verglasungseinheit eine zweite strukturierte Oberfläche aufweisen. Auch diese kann durch Sandstrahlen, Prägen, Ätzen, Gießen oder Walzen hergestellt werden. Sofern eine Unterteilung in erste und zweite Teilflächen mit unterschiedlicher Rauheit erwünscht ist, kann eine optionale Maskierung erfolgen. Die Maske kann insbesondere durch ein Druckverfahren aufgebracht werden.

Wenn die Verglasungseinheit erste Teilflächen aufweist, welche eine erste photonische Struktur aufweisen und zweite Teilflächen aufweist, welche eine zweite photonische Struktur oder keine photonische Struktur aufweisen, kann auch vor der Erzeugung der photonischen Struktur eine Maske aufgebracht werden. Dies kann in einigen Ausführungsformen der Erfindung durch ein Druckverfahren erfolgen. Sofern die Maske aus organischem Material besteht, kann diese durch Veraschen entfernt werden. In einigen Ausführungsformen der Erfindung kann das Veraschen zeitgleich mit einer Wärmebehandlung zum Härten der Verglasungseinheit erfolgen.

Ferner wird erfindungsgemäß ein Solarmodul bereitgestellt, das eine erfindungsgemäße Verglasungseinheit, insbesondere wie sie vorstehend beschrieben wurde, aufweist. Dabei kann die erfindungsgemäße Verglasungseinheit in an sich bekannten Solarmodulen vorhanden sein. Insbesondere kann das Solarmodul die Verglasungseinheit, einen ersten Einbettungsfilm, eine Solarzelle, einen zweiten Einbettungsfilm und eine Rückseitenfolie aufweisen. Beispiele für die Materialien des Einbettungsfilms sind Ethylenvinylacetat und/oder Silikon.

In einigen Ausführungsformen kann die Verglasungseinheit auf einen an sich bekannten thermischen Solarkollektor aufgebracht sein.

Die erfindungsgemäße Verglasungseinheit kann zur ästhetischen Gestaltung einer Vielzahl unterschiedlichster Flächen und Oberflächen verwendet werden. Dabei ist es möglich, dass ein Teil der Fläche/Oberfläche mit der erfindungsgemäßen Verglasungseinheit verglast ist und andere Teile der Fläche/Oberfläche in üblicher Weise gestaltet sind.

Die erfindungsgemäße Verglasungseinheit kann als Abdeckglas für bauwerksintegrierte Photovoltaik (BIPV), gebäudeintegrierte Solarthermie, Aufdachanlagen mit besonderer farblicher Gestaltung, als normale nichtsolare Verglasung beispielsweise im Brüstungsbereich von vollverglasten Gebäuden oder als farbige Fahrzeugverglasung. Im letzten Fall kann ein Schriftzug, ein Muster oder ein Logo eingebracht werden und durch den Schriftzug trotzdem noch Licht durch die Verglasung in den dahinterliegenden Raum gelangen.

Nachfolgend soll die Erfindung anhand von Figuren und Ausführungsbeispielen ohne Beschränkung des allgemeinen Erfindungsgedankens näher erläutert werden. Dabei zeigt:
- Fig. 1: eine erfindungsgemäße Verglasungseinheit in einer ersten Ausführungsform.
- Fig. 2: zeigt eine zweite Ausführungsform der erfindungsgemäßen Verglasungseinheit.
- Fig. 3: zeigt eine dritte Ausführungsform der erfindungsgemäßen Verglasungseinheit.
- Fig. 4: zeigt eine vierte Ausführungsform der erfindungsgemäßen Verglasungseinheit.
- Fig. 5a: und b zeigen eine fünfte Ausführungsform der erfindungsgemäßen Verglasungseinheit.
- Fig. 6: zeigt eine sechste Ausführungsform der erfindungsgemäßen Verglasungseinheit.

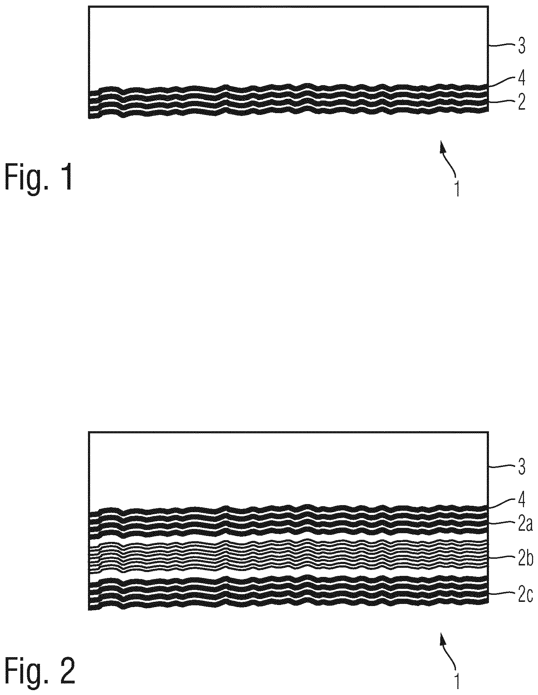

Fig. 1 zeigt eine erste Ausführungsform der erfindungsgemäßen Verglasungseinheit 1. Dabei ist in Fig. 1 eine dreidimensionale photonische Struktur 2 und ein Glas 3 dargestellt, wobei das Glas 3 eine erste strukturierte Oberfläche 4 aufweist, auf die die dreidimensionale photonische Struktur 2 aufgebracht ist.

Das Glas 3 stellt ein Trägermaterial für die dreidimensionale photonische Struktur dar. Das Glas 3 ist ein transparentes oder transluzentes Material, welches auch aus mehreren, nicht dargestellten Schichten aus unterschiedlichen Materialien zusammengesetzt sein kann. Beispielsweise kann das Glas 3 mit einer Vergütungsschicht versehen sein oder als Verbundsicherheitsglas zumindest eine Polymerfolie enthalten, welche vollflächig mit benachbarten Glasschichten verbunden ist.

Die dreidimensionale photonische Struktur 2 ist in dieser ersten Ausführungsform als Dünnschichtfilter aus mehreren alternierenden Einzelschichten aufgebaut, welche jeweils Si₃N₄ oder TiO₂ enthalten. Durch die Wahl der Schichtabstände kann die Reflexionswellenlänge und damit die Farbgestaltung der Verglasungseinheit 1 gewählt werden, so dass sie eine bestimmte Farbe, beispielsweise rot, zeigt. Die Schichtabstände können zwischen etwa 100 nm und etwa 250 nm gewählt werden. Die Zahl der Einzelschichten kann zwischen 1 und etwa 100 oder zwischen etwa 3 und etwa 20 betragen.

Die Einzelschichten der photonische Struktur 2 sind auf einer strukturierten Oberfläche 4 aufgebracht, welche durch Sandstrahlen, Walzen, Ätzen, Gießen oder Prägen in an sich bekannter Weise hergestellt werden kann.

Da das Glas 3 eine strukturierte Oberfläche 4 aufweist, ist das Dünnschichtfilter damit ebenfalls strukturiert, sodass dieses nicht wie sonst üblich als planer Dünnschichtfilter betrachtet werden kann. Das Dünnschichtfilter kann dennoch als Bragg-Filter oder als ähnliches Filter designt werden. Erfindungsgemäß wurde jedoch erkannt, dass sich einige Eigenschaften der als Dünnschichtfilter designten Struktur durch das Aufbringen auf ein strukturiertes Glas 3 wesentlich ändern, sodass nicht mehr von einem eindimensionalen Dünnschichtfilter gesprochen werden kann. Erhalten bleiben bei dieser Realisierungsform die Hauptreflexionsmaxima, aber auch höhere Harmonische der Dünnschichtstruktur, wobei deren genaue Lage durch die Schichtfolge der Einzelschichten des Dünnschichtfilters beeinflusst werden kann. Einer der wesentlichen Einflüsse der strukturierten Oberfläche ist ein Einfluss auf die Winkelabhängigkeit der Reflexionspeaks. Die Farbgestaltung der Verglasungseinheit 1 weist bei Änderung des Betrachtungswinkels eine geringere Variation auf als bekannte, farbige Verglasungseinheiten. Gleichzeitig ist die Transmission für das für die solare Energieerzeugung verwendbare Spektrum größer als bei bekannten, insbesondere pigmentierten farbigen Verglasungseinheiten.

In Fig. 2 wird eine zweite Ausführungsform der erfindungsgemäßen Verglasungseinheit 1 gezeigt, bei der auf der strukturierten Oberfläche 4 des Glases 3 drei unterschiedliche dreidimensionale photonische Strukturen 2a, 2b, 2c erzeugt worden sind. Diese unterscheiden sich darin, dass sie unterschiedliche Farben zeigen, d.h. Licht bei jeweils unterschiedlichen Wellenlängen reflektieren. Auf diese Weise ist es möglich, durch Überlagung von drei Grundfarben auch Mischfarben zu erzeugen und damit die Gestaltungsmöglichkeiten weiter zu erhöhen.

Die unterschiedlichen dreidimensionalen photonischen Strukturen 2a, 2b und 2c können durch hintereinander erfolgendes Sputtern auf die zuvor strukturierte Oberfläche 4 des Glases 3 aufgebracht werden. Die photonischen Strukturen 2a, 2b und 2c können sich durch die Zusammensetzung und/oder die Dicke und/oder die Anzahl der Einzelschichten unterscheiden.

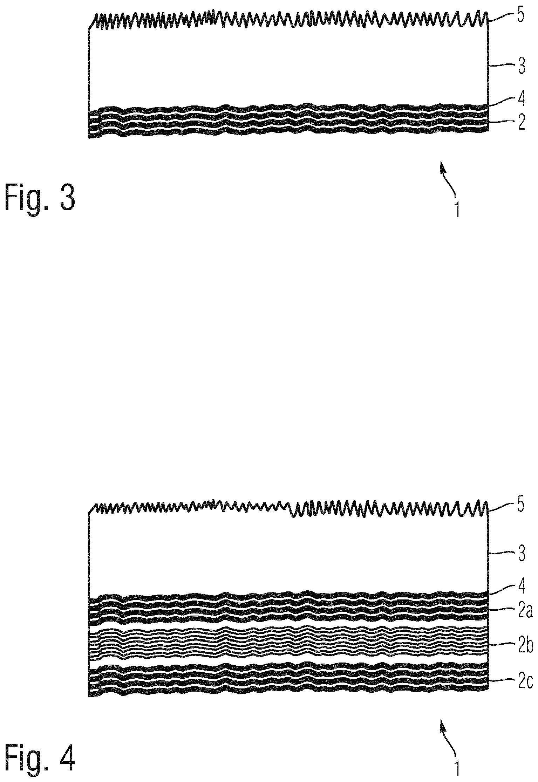

Die dritte Ausführungsform der erfindungsgemäßen Verglasungseinheit 1 nach Fig. 3 zeigt, dass das Glas 3 eine zweite strukturierte Oberfläche 5 aufweist, die sich gegenüber der ersten strukturierten Oberfläche 4 des Glases 3 befindet.

Die zweite strukturierte Oberfläche 5 kann dazu dienen, unerwünschte Spiegelungen an der Oberfläche zu vermeiden, welche Passanten blenden könnten und die durch die Verglasungseinheit hindurchtretende Intensität weiter reduzuieren können.

Die vierte Ausführungsform der erfindungsgemäßen Verglasungseinheit 1 weist ebenfalls eine zweite strukturierte Oberfläche 5, ein Glas 3 und eine erste strukturierte Oberfläche 4 auf. Insofern entspricht sie der in der Fig. 3 dargestellten dritten Ausführungsform der erfindungsgemäßen Verglasungseinheit. Die Verglasungseinheit 1 gemäß der Fig. 4 weist aber, ähnlich wie Fig. 2, drei unterschiedliche dreidimensionalen photonische Strukturen 2a, 2b und 2c auf, die einen unterschiedlichen farblichen Eindruck hervorrufen, so dass insgesamt der Gesamteindruck einer Mischfarbe entsteht.

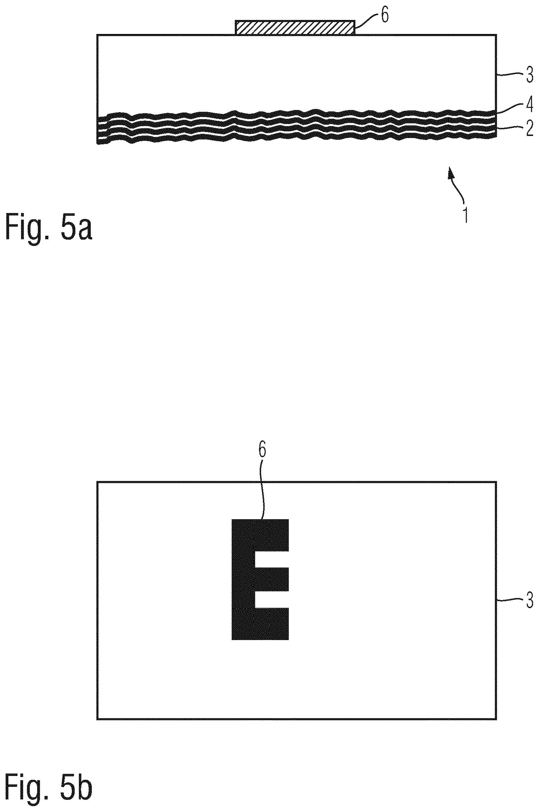

Die in den Fig. 5a und 5b gezeigte fünfte Ausführungsform der erfindungsgemäßen Verglasungseinheit weist eine dreidimensionale photonische Struktur 2, eine strukturierte Oberfläche 4 und ein Glas 3 auf. Auf der Oberfläche des Glases 3, befindet sich ein gestalterisches Element 6. Dieses kann im einfachsten Fall mit einer Klebefolie erzeugt werden. In der Fig. 5a ist dies im Querschnitt dargestellt, und in der Fig. 5b als Draufsicht, in der das gestalterische Element in Form eines Buchstabens zu Zwecken der Illustration veranschaulicht ist.

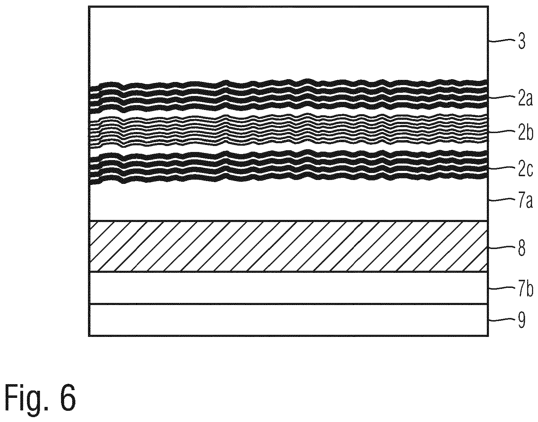

Vorteilhaft ist jedoch, dass die Verglasungseinheit zur Erzeugung eines gestalterischen Elements erste Teilflächen aufweist, welche eine erste photonische Struktur aufweisen und zweite Teilflächen aufweist, welche eine zweite photonische Struktur oder keine photonische Struktur aufweisen. Wenn Teilflächen der Verglasungseinheit keine photonische Struktur aufweisen, erscheinen diese schwarz. Wenn ausgewählte Teilflächen der Verglasungseinheit eine andere photonische Struktur aufweisen als andere Teilflächen, so können diese in einer anderen Farbe erscheinen, wenn sich die Schichtdicken und/oder das Material der Einzelschichten und/oder oder die Anzahl der Einzelschichten unterscheiden. In anderen Ausführungsformen der Erfindung können Teilflächen mit dem identischen Bragg-Filter versehen sein, aber eine geringere Rauheit bzw. eine andere Oberflächenstrukturierung aufweisen. Hierdurch kann sich eine größere Winkelabhängigkeit des Farbeindruckes einstellen. Durch die Aufteilung in erste und zweite Teilflächen können Muster, Logos oder andere gestalterische Elemente auf der Verglasungseinheit ausgeführt werden. Gleichzeitig bleibt die hohe Transmission als wesentlicher Vorteil der Erfindung über die gesamte Fläche erhalten. Figur 6 zeigt eine sechste Ausführungsform der Erfindung. In dieser wird gezeigt, wie eine erfindungsgemäße Verglasungseinheit 1 in ein Solarmodul eingebaut ist. Dabei weist das Solarmodul die Verglasungseinheit 1 als Deckglas auf.

Die erfindungsgemäße Verglasungseinheit mit dem Glas 3 und der photonischen Struktur 2 befindet sich auf einer ersten Einbettungsfolie 7a, die beispielsweise aus Ethylenvinylacetat oder Silikon hergestellt ist. Weiterhin enthält das Solarmodul eine zweite Einbettungsfolie 7b. Die Einbettungsfolien 7a, 7b schließen zumindest eine photovoltaische Zelle 8 ein. Dabei kann es sich um eine an sich bekannte photovoltaische Zelle handeln. Die Erfindung lehrt nicht die Verwendung einer bestimmten Zelle als Lösungsprinzip. Schließlich weist das Solarmodul eine übliche Rückseitenfolie 9 auf. Solche Solarmodule können für die gebäudeintegrierte Photovoltaik verwendet werden. Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal vorhanden ist. Dies schließt die Anwesenheit weiterer Merkmale nicht aus. Sofern die vorstehende Beschreibung "erste" und "zweite" Ausführungsformen definiert, so dient diese Bezeichnung der Unterscheidung zweier gleichartiger Ausführungsformen, ohne eine Rangfolge festzulegen.

## Patentansprüche

1. Verglasungseinheit (1) zur ästhetischen Gestaltung, die mindestens ein Glas (3) enthält oder daraus besteht, wobei das Glas (3) eine erste strukturierte Oberfläche (4) aufweist, auf welche eine photonische Struktur (2) aufgebracht ist, welche dazu eingerichtet ist, ein erstes Teilspektrum eintreffender elektromagnetischer Strahlung zu reflektieren und ein zweites Teilspektrum eintreffender elektromagnetischer Strahlung zu transmittieren, **dadurch gekennzeichnet, dass** der reflektierte Anteil einer höheren Harmonischen entspricht und im sichtbaren Spektralbereich liegt.

2. Verglasungseinheit (1) nach Anspruch 1, wobei der mittlere Brechungsindex der photonischen Struktur (2) größer als etwa 1,6 oder größer als etwa 1,8 oder größer als etwa 1,95 ist.

3. Verglasungseinheit (1) nach einem der Ansprüche 1 oder 2, wobei die photonische Struktur (2) einen Bragg-Filter enthält oder daraus besteht.

4. Verglasungseinheit (1) nach einem der Ansprüche 1 bis 3, wobei die photonische Struktur (2) erste Schichten aufweist, welche ein erstes Material enthalten, welches einen ersten Brechungsindex aufweist und die photonische Struktur (2) zweite Schichten aufweist, welche ein zweites Material enthalten, welches einen zweiten Brechungsindex aufweist, wobei der erste Brechungsindex zwischen etwa 1,5 und etwa 2,2 beträgt und der zweite Brechungsindex zwischen etwa 1,8 und etwa 2,5 beträgt.

5. Verglasungseinheit (1) nach einem der Ansprüche 1 bis 4, wobei die photonische Struktur (2) einen der folgenden Schichtaufbauten aufweist:
- Si₃N₄ in einer Dicke von 140 nm, TiO₂ in einer Dicke von 170 nm, Si₃N₄ in einer Dicke von 200 nm, TiO₂ in einer Dicke von 170 nm und Si₃N₄ in einer Dicke von 140 nm, oder
- Si₃N₄ in einer Dicke von 165 nm, TiO₂ in einer Dicke von 190 nm, Si₃N₄ in einer Dicke von 240 nm, TiO₂ in einer Dicke von 190 nm und Si₃N₄ in einer Dicke von 165 nm, oder
- Si₃N₄ in einer Dicke von 120 nm, TiO₂ in einer Dicke von 140 nm, Si₃N₄ in einer Dicke von 170 nm, TiO₂ in einer Dicke von 140 nm und Si₃N₄ in einer Dicke von 120 nm, oder
- Si₃N₄ in einer Dicke von 140 nm, TiO₂ in einer Dicke von 170 nm und Si₃N₄ in einer Dicke von 140 nm, oder
- Si₃N₄ in einer Dicke von 165 nm, TiO₂ in einer Dicke von 190 nm und Si₃N₄ in einer Dicke von 165 nm, oder
- Si₃N₄ in einer Dicke von 120 nm, TiO₂ in einer Dicke von 140 nm und Si₃N₄ in einer Dicke von 120 nm.

6. Verglasungseinheit (1) nach Anspruch 5, weiterhin enthaltend eine SiO₂-Schicht mit einer Dicke von etwa 100 nm bis etwa 230 nm oder von etwa 3 nm bis etwa 100 nm als den Schichtaufbau abschließende Deckschicht.

7. Verglasungseinheit (1) nach einem der Ansprüche 1 bis 6, wobei die Verglasungseinheit (1) mehrere photonische Strukturen (2a, 2b, 2c) aufweist, welche jeweils ein unterschiedliches erstes Teilspektrum reflektieren und/oder das Glas (3) eine zweite strukturierte Oberfläche (5) aufweist, die sich gegenüber der ersten strukturierten Oberfläche (4) des Glases (3) befindet, wobei optional auf der zweiten strukturierten Oberfläche (5) zumindest eine zweite photonische Struktur angeordnet ist.

8. Verglasungseinheit (1) nach einem der Ansprüche 1 bis 7, wobei diese erste Flächenbereiche aufweist, welche eine erste photonische Struktur (2) aufweisen und zweite Flächenbereiche aufweist, welche eine zweite photonische Struktur oder keine photonische Struktur aufweisen und/oder das Glas (3) zumindest eine Teilfläche eines Glasbausteins oder eines Glasdachziegels oder eines Fensterglases ist.

9. Verfahren zur Herstellung einer Verglasungseinheit (1) zur ästhetischen Gestaltung, die mindestens eine photonische Struktur (2) und ein Glas (3) umfasst oder daraus besteht, **gekennzeichnet durch** folgende Schritte: Bereitstellen eines Glases (3), Herstellen einer ersten strukturierten Oberfläche (4) auf dem Glas (3) und Aufbringen der photonischen Struktur (2) auf der ersten strukturierten Oberfläche (4), so dass diese dazu eingerichtet ist, ein erstes Teilspektrum eintreffender elektromagnetischer Strahlung zu reflektieren und ein zweites Teilspektrum eintreffender elektromagnetischer Strahlung zu transmittieren, **dadurch** gekennzeichnet, dass der reflektierte Anteil einer höheren Harmonischen entspricht und im sichtbaren Spektralbereich liegt.

10. Verfahren nach Anspruch 9, wobei das Aufbringen der photonischen Struktur (2) auf der ersten strukturierten Oberfläche (4) des Glases (3) durch Sputtern erfolgt.

11. Verfahren nach Anspruch 9 oder 10, wobei die Herstellung der ersten strukturierten Oberfläche (4) durch Sandstrahlen, Ätzen, Prägen, Gießen oder Walzen erfolgt.

12. Verfahren nach einem der Ansprüche 9 bis 11, wobei auf der ersten strukturierten Oberfläche (4) vor dem Aufbringen der photonischen Struktur (2) eine Maske erzeugt wird, welche nach dem Aufbringen der photonischen Struktur (2) entfernt wird.

13. Verfahren nach Anspruch 12, wobei das Entfernen der Maske durch Veraschen erfolgt, insbesondere zeitgleich mit dem Härten der Verglasungseinheit (1) und/oder das Erzeugen der Maske durch Drucken erfolgt.

14. Solarmodul, enthaltend zumindest eine Verglasungseinheit (1) nach einem der Ansprüche 1 bis 8, zumindest einen ersten Einbettungsfilm (7a), zumindest eine Solarzelle (8), zumindest einen zweiten Einbettungsfilm (7b) und zumindest eine Rückseitenfolie (9).

15. Thermischer Solarkollektor mit einer Verglasungseinheit nach einem der Ansprüche 1 bis 8.

## Claims

1. Glazing unit (1) for an esthetically pleasing effect, comprising or consisting of at least one glass (3),
the glass (3) having a first structured surface (4) to which a photonic structure (2) is applied which is configured to reflect a first partial spectrum of incident electromagnetic radiation and to transmit a second partial spectrum of incident electromagnetic radiation, **characterized in that** the reflected proportion corresponds to a higher harmonic and is in the visible spectral range.

2. Glazing unit (1) according to claim 1, wherein the mean refractive index of the photonic structure (2) is greater than about 1.6 or greater than about 1.8 or greater than about 1.95.

3. Glazing unit (1) according to any of claims 1 or 2, wherein the photonic structure (2) contains or consists of a Bragg filter.

4. Glazing unit (1) according to any of claims 1 to 3, wherein the photonic structure (2) comprises first layers containing a first material having a first refractive index and the photonic structure (2) comprises second layers containing a second material having a second refractive index, the first refractive index being between about 1.5 and about 2.2 and the second refractive index being between about 1.8 and about 2.5.

5. Glazing unit (1) according to any of claims 1 to 4, wherein the photonic structure (2) has one of the following layer structures:
- Si₃N₄ in a thickness of 140 nm, TiO₂ in a thickness of 170 nm, Si₃N₄ in a thickness of 200 nm, TiO₂ in a thickness of 170 nm and Si₃N₄ in a thickness of 140 nm, or
- Si₃N₄ in a thickness of 165 nm, TiO₂ in a thickness of 190 nm, Si₃N₄ in a thickness of 240 nm, TiO₂ in a thickness of 190 nm and Si₃N₄ in a thickness of 165 nm, or
- Si₃N₄ in a thickness of 120 nm, TiO₂ in a thickness of 140 nm, Si₃N₄ in a thickness of 170 nm, TiO₂ in a thickness of 140 nm and Si₃N₄ in a thickness of 120 nm, or
- Si₃N₄ in a thickness of 140 nm, TiO₂ in a thickness of 170 nm and Si₃N₄ in a thickness of 140 nm, or
- Si₃N₄ in a thickness of 165 nm, TiO₂ in a thickness of 190 nm and Si₃N₄ in a thickness of 165 nm, or
- Si₃N₄ in a thickness of 120 nm, TiO₂ in a thickness of 140 nm and Si₃N₄ in a thickness of 120 nm.

6. Glazing unit (1) according to claim 5, further comprising an SiO₂ layer having a thickness of about 100 nm to about 230 nm or of about 3 nm to about 100 nm as a cover layer completing the layer structure.

7. Glazing unit (1) according to any of claims 1 to 6, wherein the glazing unit (1) comprises a plurality of photonic structures (2a, 2b, 2c) each reflecting a different first partial spectrum, and/or the glass (3) has a second structured surface (5), which is arranged opposite the first structured surface (4) of the glass (3), optionally at least one second photonic structure being arranged on the second structured surface (5).

8. Glazing unit (1) according to any of claims 1 to 7, wherein it comprises first surface regions having a first photonic structure (2) and second surface regions having a second photonic structure or no photonic structure and/or the glass (3) is at least one partial area of a glass brick or a glass roof tile or a window glass.

9. Method for producing a glazing unit (1) for the esthetically pleasing effect, comprising or consisting of at least one photonic structure (2) and a glass (3), **characterized by** the following steps:
providing a glass (3), forming a first structured surface (4) on the glass (3) and applying the photonic structure (2) to the first structured surface (4) so that it is configured to reflect a first partial spectrum of incident electromagnetic radiation and to transmit a second partial spectrum of incident electromagnetic radiation, **characterized in that** the reflected proportion corresponds to a higher harmonic and is in the visible spectral range.

10. Method according to claim 9, wherein the photonic structure (2) is applied to the first structured surface (4) of the glass (3) by sputtering.

11. Method according to claim 9 or 10, wherein the first structured surface (4) is produced by sandblasting, etching, embossing, casting or rolling.

12. Method according to any of claims 9 to 11, wherein a mask is produced on the first structured surface (4) before the application of the photonic structure (2), which mask is removed after the application of the photonic structure (2).

13. Method according to claim 12, wherein the mask is removed by ashing, in particular at the same time as the glazing unit (1) is cured, and/or
the mask is produced by printing.

14. Solar module containing at least one glazing unit (1) according to any of claims 1 to 8, at least one first embedding film (7a), at least one solar cell (8), at least one second embedding film (7b) and at least one backside film (9).

15. Thermal solar collector with a glazing unit according to any of claims 1 to 8.

## Revendications

1. Unité de vitrage (1) de conception esthétique, qui comprend ou consiste en au moins un verre (3),
dans laquelle
le verre (3) présente une première surface structurée (4) sur laquelle est déposée une structure photonique (2) qui est conçue pour réfléchir un premier spectre partiel de rayonnement électromagnétique incident et pour transmettre un second spectre partiel de rayonnement électromagnétique incident,
**caractérisée en ce que**
la part réfléchie correspond à un harmonique supérieur et se situe dans la plage spectrale visible.

2. Unité de vitrage (1) selon la revendication 1,
dans laquelle l'indice de réfraction moyen de la structure photonique (2) est supérieur à environ 1,6 ou supérieur à environ 1,8 ou supérieur à environ 1,95.

3. Unité de vitrage (1) selon l'une des revendications 1 ou 2,
dans laquelle la structure photonique (2) comprend ou consiste en un filtre de Bragg.

4. Unité de vitrage (1) selon l'une des revendications 1 à 3,
dans laquelle la structure photonique (2) comprend des premières couches contenant un premier matériau ayant un premier indice de réfraction et la structure photonique (2) comprend des secondes couches contenant un second matériau ayant un second indice de réfraction, et
le premier indice de réfraction est compris entre environ 1,5 et environ 2,2 et le second indice de réfraction est compris entre environ 1,8 et environ 2,5.

5. Unité de vitrage (1) selon l'une des revendications 1 à 4,
dans laquelle la structure photonique (2) présente l'une des structures de couches suivantes :
- Si₃N₄ d'une épaisseur de 140 nm, TiO₂ d'une épaisseur de 170 nm, Si₃N₄ d'une épaisseur de 200 nm, TiO₂ d'une épaisseur de 170 nm, et Si₃N₄ d'une épaisseur de 140 nm, ou
- Si₃N₄ d'une épaisseur de 165 nm, TiO₂ d'une épaisseur de 190 nm, Si₃N₄ d'une épaisseur de 240 nm, TiO₂ d'une épaisseur de 190 nm, et Si₃N₄ d'une épaisseur de 165 nm, ou
- Si₃N₄ d'une épaisseur de 120 nm, TiO₂ d'une épaisseur de 140 nm, Si₃N₄ d'une épaisseur de 170 nm, TiO₂ d'une épaisseur de 140 nm, et Si₃N₄ d'une épaisseur de 120 nm, ou
- Si₃N₄ d'une épaisseur de 140 nm, TiO₂ d'une épaisseur de 170 nm et Si₃N₄ d'une épaisseur de 140 nm, ou
- Si₃N₄ d'une épaisseur de 165 nm, TiO₂ d'une épaisseur de 190 nm et Si₃N₄ d'une épaisseur de 165 nm, ou
- Si₃N₄ d'une épaisseur de 120 nm, TiO₂ d'une épaisseur de 140 nm et Si₃N₄ d'une épaisseur de 120 nm.

6. Unité de vitrage (1) selon la revendication 5, comprenant en outre une couche de SiO₂ ayant une épaisseur d'environ 100 nm à environ 230 nm ou d'environ 3 nm à environ 100 nm, comme couche de couverture terminant la structure de couches.

7. Unité de vitrage (1) selon l'une des revendications 1 à 6,
dans laquelle l'unité de vitrage (1) présente plusieurs structures photoniques (2a, 2b, 2c) reflétant chacune un premier spectre partiel différent, et/ou
le verre (3) présente une seconde surface structurée (5) située à l'opposé de la première surface structurée (4) du verre (3), et
optionnellement, au moins une seconde structure photonique est disposée sur la seconde surface structurée (5).

8. Unité de vitrage (1) selon l'une des revendications 1 à 7,
comprenant des premières zones de surface ayant une première structure photonique (2) et des secondes zones de surface ayant une seconde structure photonique ou n'ayant pas de structure photonique, et/ou le verre (3) est au moins une surface partielle d'une brique de verre ou d'une tuile de verre ou d'une vitre de fenêtre.

9. Procédé de fabrication d'une unité de vitrage (1) de conception esthétique, qui comprend ou consiste en au moins une structure photonique (2) et un verre (3),
**caractérisé par** les étapes suivantes consistant à :
fournir un verre (3),
réaliser une première surface structurée (4) sur le verre (3), et
déposer la structure photonique (2) sur la première surface structurée (4) de manière à ce qu'elle soit conçue pour réfléchir un premier spectre partiel de rayonnement électromagnétique incident et pour transmettre un second spectre partiel de rayonnement électromagnétique incident,
**caractérisé en ce que**
la part réfléchie correspond à un harmonique supérieur et se situe dans la plage spectrale visible.

10. Procédé selon la revendication 9,
dans lequel la déposition de la structure photonique (2) sur la première surface structurée (4) du verre (3) est effectuée par pulvérisation cathodique.

11. Procédé selon la revendication 9 ou 10,
dans lequel la réalisation de la première surface structurée (4) est effectuée par sablage, gravure chimique, estampage, coulée ou laminage.

12. Procédé selon l'une des revendications 9 à 11,
dans lequel un masque est réalisé sur la première surface structurée (4) avant la déposition de la structure photonique (2), lequel masque est retiré après la déposition de la structure photonique (2).

13. Procédé selon la revendication 12,
dans lequel le retrait du masque est effectué par incinération, en particulier simultanément au durcissement de l'unité de vitrage (1), et/ou le masque est réalisé par impression.

14. Module solaire comprenant au moins une unité de vitrage (1) selon l'une des revendications 1 à 8, au moins un premier film d'enrobage (7a), au moins une cellule solaire (8), au moins un second film d'enrobage (7b) et au moins une feuille de face arrière (9).

15. Collecteur solaire thermique comprenant une unité de vitrage selon l'une des revendications 1 à 8.
